(19) Europäisches Patentamt
European Patent Office
Office européen des brevets

(11) **EP 3 089 269 B1**

(12) **FASCICULE DE BREVET EUROPEEN**

(45) Date de publication et mention
de la délivrance du brevet:
**30.08.2017 Bulletin 2017/35**

(51) Int Cl.:
***E04B 1/92*** *(2006.01)*       ***H05K 9/00*** *(2006.01)*
***H01Q 17/00*** *(2006.01)*

(21) Numéro de dépôt: **16164687.2**

(22) Date de dépôt: **11.04.2016**

(54) **DISPOSITIF D'ABSORPTION D'ONDES ELECTROMAGNETIQUES DESTINE A ETRE FIXE SUR UNE PAROI**

ABSORPTIONSVORRICHTUNG FÜR ELEKTROMAGNETISCHE WELLEN ZUR BEFESTIGUNG AN EINER WAND

ARRANGEMENT FOR ABSORBING ELECTROMAGNETIC WAVES INTENDED FOR BEING ATTACHED TO A WALL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.04.2015 FR 1553909**

(43) Date de publication de la demande:
**02.11.2016 Bulletin 2016/44**

(73) Titulaire: **Airbus Operations (S.A.S.)**
**31060 Toulouse (FR)**

(72) Inventeurs:
• **THAIN, Andrew**
**32600 L'Isle Jourdain (FR)**
• **HERVE, Alexandre**
**31300 Toulouse (FR)**
• **JABER, ANASS**
**31100 Toulouse (FR)**

(74) Mandataire: **Gicquel, Olivier Yves Gérard**
**Airbus Opérations (S.A.S.)**
**Intellectual Property Department**
**316, route de Bayonne**
**ETRT - M0101/1**
**31060 Toulouse Cedex 9 (FR)**

(56) Documents cités:
**EP-A1- 1 860 733**

• **YUMEI CHANG ET AL: "Theoretical investigation on wideband folded dipole microwave absorber using filtering concept", MICROWAVE CONFERENCE PROCEEDINGS (APMC), 2012 ASIA-PACIFIC, IEEE, 4 décembre 2012 (2012-12-04), pages 565-567, XP032316194, DOI: 10.1109/APMC.2012.6421665 ISBN: 978-1-4577-1330-9**
• **CHANG YUMEI ET AL: "Broadband Dual-Polarization Microwave Absorber Based on Broadside-Folded Dipole Array With Triangle-Lattice Cells", IEEE ANTENNAS AND WIRELESS PROPAGATION LETTERS, vol. 13, 16 juin 2014 (2014-06-16), pages 1084-1087, XP011551770, ISSN: 1536-1225, DOI: 10.1109/LAWP.2014.2327961 [extrait le 2014-06-16]**

**Description**

La présente invention concerne un dispositif d'absorption d'ondes électromagnétiques, en particulier dans le domaine VHF et UHF, qui est destiné à équiper une paroi, telle qu'une paroi extérieure d'un bâtiment, ainsi qu'un bâtiment comportant au moins une paroi équipée d'un tel dispositif d'absorption.

L'invention se rapporte au domaine général de l'absorption des ondes électromagnétiques, des ondes radio en particulier, et plus particulièrement à celui de la prévention des effets des ondes radioélectriques réfléchies par des structures telles que des façades de bâtiments sur l'espace environnant de telles structures. L'invention s'applique plus particulièrement en zone aéroportuaire afin d'éviter que des perturbations perturbent les systèmes de mesures radioélectriques.

A cause de la présence de nombreuses sources radioélectriques, notamment les antennes ILS (« Instrument Landing System » en terminologie anglo-saxonne) elles-mêmes, le problème des réflexions parasites par les bâtiments est un problème important dont la résolution passe généralement par l'élaboration d'un plan d'implantation comportant des zones, notamment les zones relativement proches des pistes où l'on s'interdit de placer une quelconque construction de taille un tant soit peu importante. Or compte tenu, notamment, de la concentration urbaine et de la volonté de placer les zones aéroportuaires à des distances relativement faibles des zones urbaines, il devient de plus en plus nécessaire de maximiser le taux d'occupation des zones aéroportuaires en termes de surface. Par la suite, trouver une solution aux problèmes de réflexions parasites de signaux radioélectriques dans des directions sensibles apparaît plus que jamais actuel.

Les solutions actuelles sont basées sur la mise en place d'écrans sous forme de dispositifs de diffraction. Ces écrans sont constitués d'éléments disposés périodiquement sur la paroi du bâtiment. De tels écrans comme ceux décrits dans le document FR-A-2 983 577 permettent de réfléchir les ondes électromagnétiques sans les absorber. Pour absorber les ondes électromagnétiques, il est actuellement possible de disposer des mousses absorbantes, mais ces mousses sont épaisses et ne sont pas adaptées à un usage extérieur.

Yumei Chang et al "Broadband Dual-Polarization Microwave Absorber Based on Broadside-Folded Dipole Array with Triangle-Lattice Cells" divulgue un dispositif d'absorption comprenant des dipôles repliés et résistifs en regard d'un plan conducteur.

Yumei Chang et al "Theoretical Investigation on Wideband Folded Dipole Microwave Absorber Using Filtering Concept" divulgue un dispositif d'absorption comprenant des dipôles résistifs en regard d'un plan conducteur.

EP1860733 A1 divulgue un dispositif d'absorption comprenant des dipôles résistifs placés en regard d'une plaque ondulée afin de réfléchir le rayonnement incident vers les dipôles résisitifs. Un objet de la présente invention est de proposer un dispositif d'absorption d'ondes électromagnétiques qui améliore l'art antérieur et qui en particulier permet d'obtenir une absorption suffisante des ondes électromagnétiques, et qui soit en outre simple et facile à mettre en oeuvre.

A cet effet, est proposé un dispositif d'absorption d'ondes électromagnétiques destiné à être fixé sur une paroi, le dispositif d'absorption comportant :

- une plaque métallique destinée à être fixée sur la paroi,
- un panneau diélectrique à distance de la plaque métallique, et délimitant avec la plaque métallique un volume entre la plaque métallique et le panneau diélectrique,
- un réseau de dipôles résistifs, où tous les dipôles résistifs sont fixés sur une même face du panneau diélectrique, et où chacun est constitué de deux plaquettes métalliques à distance l'une de l'autre et d'une résistance disposée entre des bords en regard de deux plaquettes métalliques voisines,
- des parois métalliques électriquement connectées à la plaque métallique et s'étendant depuis la plaque métallique et en direction du panneau diélectrique. Un tel dispositif d'absorption permet d'obtenir une bonne absorption des ondes électromagnétiques.

Avantageusement, la résistance est un composant discret ou une couche résistive.

Avantageusement, le volume est rempli d'un matériau diélectrique.

Avantageusement, les parois métalliques s'étendent sur une longueur comprise entre 85% et 115% de la distance entre la plaque métallique et le panneau diélectrique.

Avantageusement, le dispositif d'absorption comporte des entretoises et une plaque de protection qui sont réalisées en matériaux diélectriques, chaque entretoise est fixée sur la plaque métallique et présente une extrémité libre qui s'étend au-delà du panneau diélectrique, et la plaque de protection est fixée à l'extrémité libre afin de protéger le dispositif d'absorption contre la pluie.

L'invention propose également un bâtiment comportant au moins une paroi et un dispositif d'absorption selon l'une des variantes précédentes, où la plaque métallique est fixée sur la paroi.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

la Fig. 1 est une vue en perspective d'un bâtiment comportant un dispositif d'absorption d'ondes électromagnétiques selon l'invention,
la Fig. 2 est une vue en perspective d'un dispositif d'absorption d'ondes électromagnétiques selon l'invention,
la Fig. 3 est une vue du dispositif d'absorption de la Fig. 2 selon la flèche III, et
la Fig. 4 montre un agrandissement d'un détail du dispositif d'absorption selon l'invention.

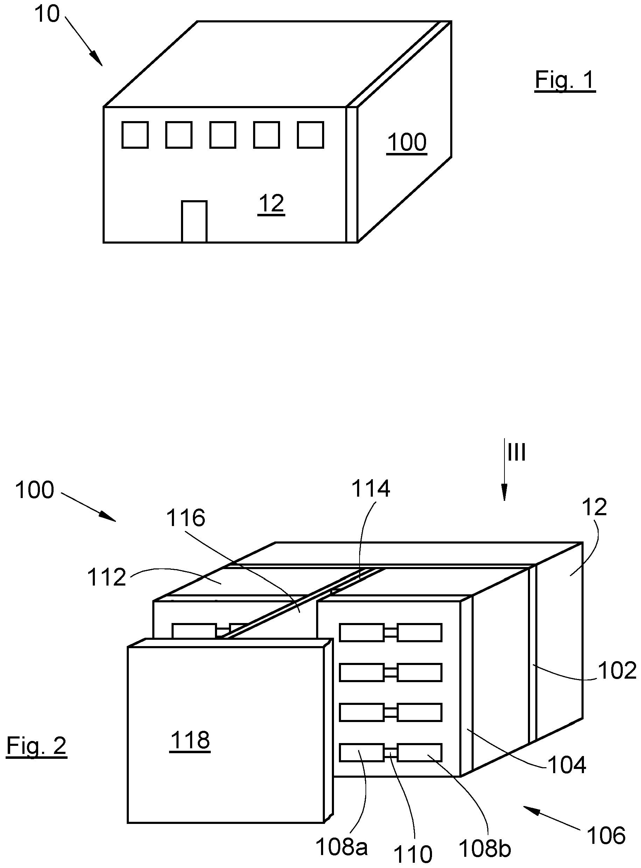

La Fig. 1 montre un bâtiment 10 qui comporte des parois extérieures 12 dont, ici, une seule est recouverte d'un dispositif d'absorption d'ondes électromagnétiques 100 selon l'invention.

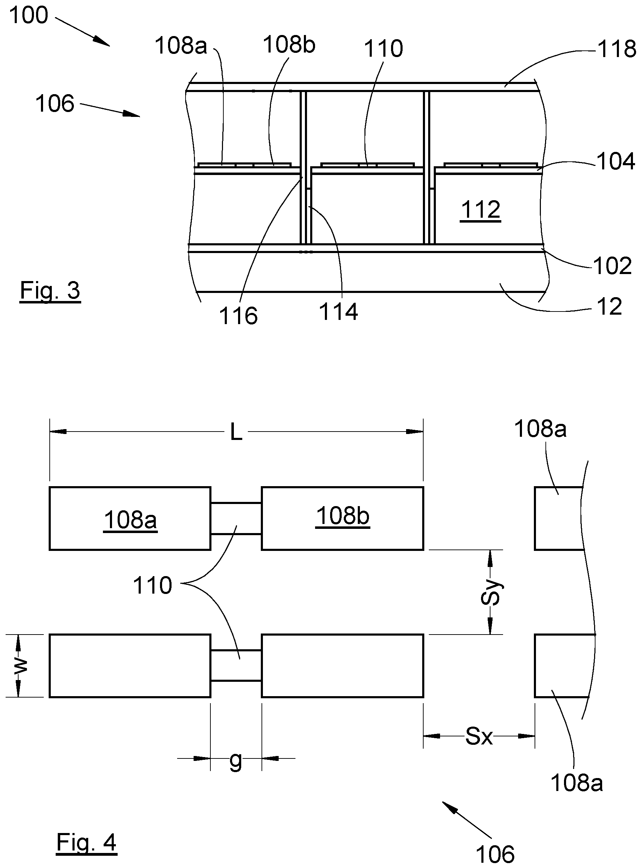

La Fig. 2 et la Fig. 3 montrent le dispositif d'absorption 100 qui est fixé sur une paroi extérieure 12.

Le dispositif d'absorption 100 comprend :

- une plaque métallique 102 destinée à être fixée sur la paroi extérieure 12 et qui constitue la masse du dispositif d'absorption 100,
- un panneau diélectrique 104 à distance de la plaque métallique 102, et délimitant avec la plaque métallique 102 un volume 112 entre la plaque métallique 102 et le panneau diélectrique 104,
- un réseau de dipôles résistifs 106, où tous les dipôles résistifs 106 sont fixés sur une même face du panneau diélectrique 104

La plaque métallique 102 est préférentiellement en aluminium, ce qui permet un allègement du dispositif d'absorption 100. La plaque métallique 102 est fixée à la paroi extérieure 12 par exemple par vissage.

Le panneau diélectrique 104 est réalisé par exemple en polycarbonate.

Chaque dipôle résistif 106 est constitué de deux plaquettes métalliques 108a-b à distance l'une de l'autre et d'une résistance 110 disposée entre des bords en regard de deux plaquettes métalliques 108a-b voisines.

Une telle géométrie génère une impédance d'entrée importante et une variation de réactance d'entrée réduite.

La résistance 110 peut être un composant discret ou une couche résistive. La valeur de la résistance 110 est égale ou proche de la composante réelle de l'impédance d'entrée du dipôle constitué par les deux plaquettes métalliques 108a-b.

La proximité des dipôles résistifs 106 entre eux permet d'annuler la composante réactive et d'augmenter la composante résistive de l'impédance d'entrée des dipôles résistifs 106.

Le réseau de dipôles résistifs 106 consiste en un ensemble de lignes parallèles entre elles et de colonnes parallèles entre elles et perpendiculaires aux lignes, où à chaque intersection ligne-colonne est placé un dipôle résistif 106.

Dans le mode de réalisation de l'invention présenté ici, le dispositif d'absorption 100 comprend des entretoises 116 fixées sur la plaque métallique 102 et traversant le volume 112. Le panneau diélectrique 104 est ici fixé sur les entretoises 116 et est parallèle à la plaque métallique 102. Les entretoises 116 sont réalisées dans un matériau diélectrique comme par exemple du polycarbonate ou du PVC.

Dans le mode de réalisation de l'invention proposé ici, tous les dipôles résistifs 106 sont fixés sur la face du panneau diélectrique 104 qui est orientée à l'opposé de la plaque métallique 102, mais dans un autre mode de réalisation, tous les dipôles résistifs 106 pourraient être fixés sur la face du panneau diélectrique 104 qui est orientée vers la plaque métallique 102.

Le volume 112 entre la plaque métallique 102 et le panneau diélectrique 104 peut être rempli d'air ou d'un matériau diélectrique comme par exemple du polystyrène extrudé.

Dans un mode de réalisation particulier, le panneau diélectrique 104 est placé à 0,15 m de la plaque métallique 102 ce qui permet de produire une fréquence de résonnance ayant une réactance moins dépendante de la fréquence et une résistance plus importante que si le panneau diélectrique 104 est placé à une distance moindre.

Pour améliorer le couplage de la capacitance entre deux dipôles résistifs 106 voisins, une pluralité de parois métalliques 114 est disposée dans le volume 112. Ces parois métalliques 114 s'étendent perpendiculairement à la plaque métallique 102 et y sont électriquement connectées. Les parois métalliques 114 s'étendent depuis la plaque métallique 102 et en direction du panneau diélectrique 104. Les parois métalliques 114 permettent également une augmentation de la réponse angulaire de la réduction de signal, ainsi qu'une augmentation de la bande passante.

Préférentiellement, les parois métalliques 114 s'étendent depuis la plaque métallique 102 sur une longueur pouvant varier de 85% à 115% de l'épaisseur du volume 112, c'est à dire de la distance entre la plaque métallique 102 et le panneau diélectrique 104.

Pour assurer une protection contre les intempéries, et en particulier l'eau de pluie, le dispositif d'absorption 100 comporte également une plaque de protection 118 et les entretoises 116 se prolongent au-delà du panneau diélectrique 104 par une extrémité libre sur laquelle se fixe la plaque de protection 118. La plaque de protection 118 est réalisée dans un matériau diélectrique comme par exemple du polycarbonate ou du PVC.

Un tel dispositif d'absorption 100 permet une bonne absorption des ondes électromagnétiques, en particulier dans les bandes UHF et VHF.

La Fig. 4 montre un agrandissement d'un ensemble de dipôles résistifs 106 selon un mode de réalisation particulier. Dans ce mode de réalisation particulier, chaque dipôle résistif 106 est constitué de deux plaquettes métalliques 108a-b rectangulaires qui sont séparées d'une distance 'g'.

Chaque plaquette métallique 108a-b présente une largeur 'w'.

La longueur totale du dipôle résistif 106 est L. La longueur de chaque plaquette métallique 108a-b est

donc $\dfrac{L-g}{2}$ .

La résistance 110 présente une résistance R.

La distance entre deux dipôles résistifs 106 voisins est Sx parallèlement à la longueur totale L, et Sy perpendiculairement à la longueur totale L.

Les différentes dimensions ainsi définies sont calculées par simulation numérique en utilisant une formule semi-analytique pour l'impédance d'entrée d'un dipôle résistif dans un réseau infini de dipôles résistifs localisé au-dessus d'un plan de masse constitué par la plaque métallique 102, comme cela est décrit dans l'article «Scan impedance for an infinite dipole array: accurate theoretical model compared to numerical software» de Makarov, Puzella et Lyer et publié le 6 décembre 2008 dans IEEE Antennas and Propagation Magazine, Vol 50, N° 6.

Dans le cas d'une fréquence de 108,55MHz sous un angle d'incidence de 53°, on obtient une absorption de 90% avec les valeurs suivantes :

L=1,2 m ; g=0,01 m ; w=0,025 m ; Sx=0,15 m ; Sy=0,7 m et R= 33 Ohms.

## Revendications

1. Dispositif d'absorption (100) d'ondes électromagnétiques destiné à être fixé sur une paroi (12), le dispositif d'absorption (100) comportant :

    - une plaque métallique (102) destinée à être fixée sur la paroi (12),
    - un panneau diélectrique (104) à distance de la plaque métallique (102), et délimitant avec la plaque métallique (102) un volume (112) entre la plaque métallique (102) et le panneau diélectrique (104),
    - un réseau de dipôles résistifs (106), où tous les dipôles résistifs (106) sont fixés sur une même face du panneau diélectrique (104), et où chacun est constitué de deux plaquettes métalliques (108a-b) à distance l'une de l'autre et d'une résistance (110) disposée entre des bords en regard de deux plaquettes métalliques (108a-b) voisines

    le dispositif d'absorption étant **caractérisé en ce qu'**il comprend également des parois métalliques (114) électriquement connectées à la plaque métallique (102) et s'étendant depuis la plaque métallique (102) et en direction du panneau diélectrique (104).

2. Dispositif d'absorption (100) selon la revendication 1, **caractérisé en ce que** la résistance (110) est un composant discret ou une couche résistive.

3. Dispositif d'absorption (100) selon l'une des revendications 1 ou 2, **caractérisé en ce que** le volume (112) est rempli d'un matériau diélectrique.

4. Dispositif d'absorption (100) selon l'une des revendications 1 à 3, **caractérisé en ce que** les parois métalliques (114) s'étendent sur une longueur comprise entre 85% et 115% de la distance entre la plaque métallique (102) et le panneau diélectrique (104).

5. Dispositif d'absorption (100) selon l'une des revendications 1 à 4, **caractérisé en ce qu'**il comporte des entretoises (116) et une plaque de protection (118) qui sont réalisées en matériaux diélectriques, chaque entretoise (116) étant fixée sur la plaque métallique (102) et présentant une extrémité libre qui s'étend au-delà du panneau diélectrique (104), et la plaque de protection (118) étant fixée à l'extrémité libre afin de protéger le dispositif d'absorption (100) contre la pluie.

6. Bâtiment (10) comportant au moins une paroi (12) et un dispositif d'absorption (100) selon l'une des revendications précédentes, où la plaque métallique (102) est fixée sur la paroi (12).

## Patentansprüche

1. Vorrichtung (100) zur Absorption elektromagnetischer Wellen, die dazu bestimmt ist, an einer Wand (12) befestigt zu werden, wobei die Absorptionsvorrichtung (100) aufweist:

    - eine Metallplatte (102), die dazu bestimmt ist, an der Wand (12) befestigt zu werden,
    - eine dielektrische Tafel (104) in Abstand zur Metallplatte (102), und die mit der Metallplatte (102) ein Volumen (112) zwischen der Metallplatte (102) und der dielektrischen Tafel (104) begrenzt,
    - ein Netz von Widerstandsdipolen (106), wobei alle Widerstandsdipole (106) auf der gleichen Seite der dielektrischen Tafel (104) befestigt sind, und wobei jeder aus zwei Metallplättchen (108a-b) in Abstand zueinander und aus einem Widerstand (110) besteht, der zwischen den gegenüberliegenden Rändern von zwei benachbarten Metallplättchen (108a-b) angeordnet ist,

    wobei die Absorptionsvorrichtung **dadurch gekennzeichnet ist, dass** sie ebenfalls Metallwände (114) enthält, die elektrisch mit der Metallplatte (102) verbunden sind und sich von der Metallplatte (102) und in Richtung der dielektrischen Tafel (104) erstrecken.

**2.** Absorptionsvorrichtung (100) nach Anspruch 1, **dadurch gekennzeichnet, dass** der Widerstand (110) ein diskretes Bauteil oder eine Widerstandsschicht ist.

**3.** Absorptionsvorrichtung (100) nach einem der Ansprüche 1 oder 2, **dadurch gekennzeichnet, dass** das Volumen (112) mit einem dielektrischen Material gefüllt ist.

**4.** Absorptionsvorrichtung (100) nach einem der Ansprüche 1 bis 3, **dadurch gekennzeichnet, dass** die Metallwände (114) sich über eine Länge erstrecken, die zwischen 85% und 115% des Abstands zwischen der Metallplatte (102) und der dielektrischen Tafel (104) liegt.

**5.** Absorptionsvorrichtung (100) nach einem der Ansprüche 1 bis 4, **dadurch gekennzeichnet, dass** sie Abstandshalter (116) und eine Schutzplatte (118) aufweist, die aus dielektrischen Materialien hergestellt sind, wobei jeder Abstandshalter (116) an der Metallplatte (102) befestigt ist und ein freies Ende aufweist, das sich über die dielektrische Tafel (104) hinaus erstreckt, und die Schutzplatte (118) am freien Ende befestigt ist, um die Absorptionsvorrichtung (100) vor Regen zu schützen.

**6.** Gebäude (10), das mindestens eine Wand (12) und eine Absorptionsvorrichtung (100) nach einem der vorhergehenden Ansprüche aufweist, wobei die Metallplatte (102) an der Wand (12) befestigt ist.

**Claims**

**1.** Device (100), intended to be fixed on a wall (12), for absorbing electromagnetic waves, the absorption device (100) comprising:

> - a metal plate (102) intended to be fixed on the wall (12),
> - a dielectric panel (104) at a distance from the metal plate (102) and delimiting, with the metal plate (102), a volume (112) between the metal plate (102) and the dielectric panel (104),
> - an array of resistive dipoles (106), all the resistive dipoles (106) being fixed on the same face of the dielectric panel (104), and each consisting of two metal platelets (108a-b) at a distance from one another and a resistor (110) arranged between the opposing edges of two neighboring metal platelets (108a-b),

the absorption device being **characterized in that** it comprises metal walls (114) electrically connected to the metal plate (102) and extending from the metal plate (102) in the direction of the dielectric panel (104).

**2.** Absorption device (100) according to Claim 1, **characterized in that** the resistor (110) is a discrete component or a resistive layer.

**3.** Absorption device (100) according to either of Claims 1 and 2, **characterized in that** the volume (112) is filled with a dielectric material.

**4.** Absorption device (100) according to one of Claims 1 to 3, **characterized in that** the metal walls (114) extend over a length of between 85% and 115% of the distance between the metal plate (102) and the dielectric panel (104).

**5.** Absorption device (100) according to one of Claims 1 to 4, **characterized in that** it comprises struts (116) and a protective plate (118) which are made of dielectric materials, each strut (116) being fixed on the metal plate (102) and having a free end which extends beyond the dielectric panel (104), the protective plate (118) being fixed to the free end in order to protect the absorption device (100) from rain.

**6.** Building (10) having at least one wall (12) and an absorption device (100) according to one of the preceding claims, wherein the metal plate (102) is fixed on the wall (12).

10

100

12

Fig. 1

100

114

116

112

III

12

102

104

106

108a

110

108b

118

Fig. 2

100

106

108a   108b   110              118

104

112

102

12

116   114

Fig. 3

L

108a

108a   108b

110

Sy

w

g

Sx

108a

Fig. 4

106

**RÉFÉRENCES CITÉES DANS LA DESCRIPTION**

**Documents brevets cités dans la description**

- FR 2983577 A

- EP 1860733 A1

**Littérature non-brevet citée dans la description**

- **YUMEI CHANG et al.** *Broadband Dual-Polarization Microwave Absorber Based on Broadside-Folded Dipole Array with Triangle-Lattice Cells*

- **MAKAROV ; PUZELLA ; LYER.** Scan impedance for an infinite dipole array: accurate theoretical model compared to numerical software. *IEEE Antennas and Propagation Magazine,* 06 Décembre 2008, vol. 50 (6